# EUROPÄISCHE PATENTSCHRIFT

(11) **EP 3 183 375 B1**
(45) Veröffentlichungstag und Bekanntmachung des Hinweises auf die Patenterteilung: **07.04.2021**
(21) Anmeldenummer: 15767073.8
(22) Anmeldetag: 10.08.2015
(51) Int. Cl.: C23C 14/34, B22F 1/00, C22C 27/04, H01L 21/02, C23C 24/04, C22C 1/04, H01B 1/02, H01L 23/532

(54) **METALLISIERUNG FÜR EIN DÜNNSCHICHTBAUELEMENT, VERFAHREN ZU DEREN HERSTELLUNG UND SPUTTERING TARGET**
METALLIZATION FOR A THIN FILM COMPONENT, METHOD FOR THE PRODUCTION THEREOF, AND SPUTTERING TARGET
MÉTALLISATION POUR UN ÉLÉMENT À COUCHE MINCE, PROCÉDÉ POUR SA FABRICATION ET CIBLE DE PULVÉRISATION

(30) Priorität: 20.08.2014 AT 3022014 U
(43) Veröffentlichungstag der Anmeldung: 28.06.2017
(73) Patentinhaber: Plansee SE, 6600 Reutte (AT)
(72) Erfinder: KÖSTENBAUER, Harald, 6600 Breitenwang (AT); KÖSTENBAUER, Judith, 6600 Breitenwang (AT); LEICHTFRIED, Gerhard, 6600 Reutte (AT); WINKLER, Jörg, A-6600 Breitenwang (AT); HWANG, Moo Sung, Gyeonggi-do (KR); KATHREIN, Martin, 6600 Reutte (AT); EIDENBERGER, Elisabeth, 6600 Breitenwang (AT)
(74) Vertreter: Ciesla, Bettina
(86) Internationale Anmeldenummer: PCT/AT2015/000106
(87) Internationale Veröffentlichungsnummer: WO 2016/025968

(56) Entgegenhaltungen:
- EP-A1- 2 690 185
- WO-A1-2014/073633
- US-A1- 2004 135 143
- US-A1- 2006 091 397

## Beschreibung

Die Erfindung betrifft eine Metallisierung für ein Dünnschichtbauelement sowie ein Verfahren zur Herstellung einer Metallisierung. Weiters betrifft die Erfindung ein Sputtering Target aus einer Mo-Basislegierung, sowie ein Verfahren zur Herstellung eines Sputtering Targets aus einer Mo-Basislegierung.

Metallisierungen für Dünnschichtbauelemente können über Sputtern von entsprechenden Sputtering Targets hergestellt werden. Das Sputtern, auch Kathodenzerstäubung genannt, ist ein physikalischer Vorgang, bei dem Atome aus einem Sputtering Target durch Beschuss mit energiereichen Ionen herausgelöst werden und in die Gasphase übergehen.

Bei Metallisierungen für Dünnschichtbauelemente kann es sich beispielsweise um Leiterbahnen und Elektroden (z.B. Source-, Drain- und Gateelektrode bei einem TFT (Thin Film Transistor / Dünnschichttransistor)) handeln, finden in einer Vielzahl von elektronischen Geräten wie beispielsweise in LCD (Liquid Crystal Display / Flüssigkristall)- oder OLED (organische lichtemittierende Diode)- Bildschirmen, in PC (Personal Computer)- Systemen oder in mobilen Geräten wie Mobiltelefonen, Smartphones, Tablet PCs, PDAs (Personal Digital Assistants), tragbaren Musikplayern, Solarzellen, etc. Verwendung.

Der Grundaufbau einer solchen Metallisierung besteht aus mindestens einer elektrisch leitfähigen Schicht, die beispielsweise als Leiterbahn oder Elektrode fungiert. Daneben sind auch mehrlagige Ausführungen solcher Metallisierungen bekannt. Eine solche elektrisch leitfähige Schicht kann beispielsweise ein Metall mit einer guten elektrischen Leitfähigkeit wie AI, Cu, Ag oder Au enthalten oder daraus bestehen. Insbesondere zur Verbesserung der Haftung auf einem Substrat kann zwischen der zumindest einen elektrisch leitfähigen Schicht und dem Substrat eine metallische Zwischenschicht aus Mo, W, Ti, Nb oder Ta oder einer Legierung auf Basis eines dieser Metalle vorgesehen sein. Diese Zwischenschicht kann in manchen Anwendungsfällen auch die Anforderungen einer Diffusionsbarriere erfüllen, wenn sie in direktem Kontakt zu einem Halbleiterwerkstoff, beispielsweise Si (a-Si / amorphes Si oder LTPS / low temperature poly silicon Schicht), steht. Weiters kann zusätzlich eine Deckschicht aus Mo, W, Ti, Nb oder Ta oder einer Legierung auf Basis eines dieser Metalle, die als Schutzschicht (zum Beispiels gegen mechanische Beschädigung, Korrosion, Oxidation, Feuchtigkeit) und/oder Diffusionsbarriere für eine angrenzende elektrisch leitfähige Schicht oder eine transparentleitfähige Schicht (transparent conductive oxide / TCO, z.B. Indium-Zinn-Oxid) dient, vorgesehen sein.

Derartige Metallisierungen, sowohl die elektrisch leitfähigen Schichten, meist metallische Schichten aus AI, Cu, Ag oder Au oder einer Legierung auf Basis eines dieser Metalle, als auch gegebenenfalls vorgesehene Zwischen- oder Deckschichten, werden üblicherweise mittels eines Gasphasenabscheideverfahrens (z.B. Sputtern) hergestellt, wobei die anschließende Strukturierung der einzelnen Schichten mittels Photolithographie in Verbindung mit einem nasschemischen oder eines trockenen Ätzprozesses erfolgt. Zur Fertigung einer mehrlagigen Metallisierung ist es vorteilhaft, wenn die einzelnen Schichten der Metallisierung jeweils eine vergleichbare Ätzrate aufweisen bzw. sich im gleichen Ätzmedium ätzen lassen. In diesem Fall kann der Ätzprozess in einem Schritt erfolgen, das Ätzmedium für die Strukturierung der einzelnen Schichten der Metallisierung muss nicht angepasst werden und in Folge können die Fertigungskosten reduziert werden.

Neben einer ausreichenden elektrischen Leitfähigkeit und einem wie beschriebenen vorteilhaften Ätzverhalten soll eine derartige Metallisierung weitere Eigenschaften aufweisen. Während des Fertigungsprozesses eines eine solche Metallisierung enthaltenden Dünnschichtbauelements kann es zu erhöhten Temperaturen in sauerstoffhaltigen Atmosphären kommen, beispielsweise bei der Herstellung von LTPS oder wenn eine Zwischenglühung an Luft erforderlich ist. Dies kann zu einer Oxidation der Metallisierung und somit zu Verfärbungen der metallischen Oberfläche führen, was wiederum zu einer Verringerung der elektrischen Leitfähigkeit oder bei (automatischer) optischer Qualitätskontrolle zu erhöhtem Ausschuss führen kann. Insbesondere mobile Geräte sind auch im Betrieb vermehrt unterschiedlichen Umwelteinflüssen (Feuchtigkeit, etc.) ausgesetzt und es kann zu einer Schädigung der Metallisierung durch Korrosion oder andere Reaktionen kommen. Dabei können wiederum die elektrische Leitfähigkeit verringert und die Funktionsweise des Dünnschichtbauelements beeinträchtigt werden.

Zusammengefasst hat eine Metallisierung für ein Dünnschichtbauelement also vielfältige elektrische, chemische und optische Anforderungen zu erfüllen. Die Metallisierung muss eine ausreichend hohe elektrische Leitfähigkeit (einen ausreichend geringen elektrischen Widerstand) und weiters einen möglichst geringen Übergangswiderstand zu den zu kontaktierenden Materialien (z.B. Halbleiterwerkstoffe, transparent leitfähige Oxide / transparent conductive oxides, TCOs) aufweisen. Die Metallisierung soll eine hohe Oxidationsbeständigkeit aufweisen, um eine Schädigung während des Fertigungsprozesses zu verhindern. Weiters soll die Metallisierung eine hohe Korrosionsbeständigkeit und Widerstandsfähigkeit gegenüber äußeren Einflüssen haben, während gleichzeitig ein hervorragendes Ätzverhalten (gute Ätzbarkeit) der Metallisierung erwünscht ist. Zusätzlich sollen für eine kostengünstige Herstellung bei mehrlagigen Metallisierungen die Ätzraten der einzelnen Schichten vergleichbar/ähnlich sein. Zusätzlich soll die Metallisierung als Diffusionsbarriere gegen die Diffusion von Silizium dienen können.

Für die Herstellung derartiger Metallisierungen werden zum Beispiel Sputtering Targets aus entsprechenden Metallen oder Legierungen eingesetzt, die über Sputtern, beispielsweise Magnetron-Sputtern, abgetragen werden. In Folge werden die in die Gasphase übergegangenen Atome des Sputtering Targets wieder am zu beschichtenden Substrat abgeschieden und eine entsprechende Schicht gebildet.

Sputtering Targets aus AI-Legierungen die zur Herstellung von Diffusionsbarrieren in Displays (Diffusion zwischen Si und Al) verwendbar sind, sind beispielsweise in der JP 2011 232654 A beschrieben. Auch die entsprechende Anwendung in einer Al-Legierungsschicht, enthaltend eine Monolage einer AI-Mo Legierung enthaltend ≥30 at% Mo oder einer Al-Mo-X Legierung enthaltend Mo und zumindest eines der Elemente X, wobei X = (Mn, Nd, Ni, Mg und Fe) ist bekannt. Zu hohe AI Gehalte in solchen Legierungsschichten können allerdings dazu führen, dass deren Eignung als Diffusionsbarriere nicht mehr erreicht wird, da AI als Diffusionsbarriere gegenüber Si nicht geeignet ist. Außerdem kann es zu unerwünschten Reaktionen zwischen Al und Mo kommen.

Ebenso sind Sputtering Targets aus Al-Seltenerd-Legierungen bekannt, wie z.B. aus der US 2012 0301732 A1*.* Dabei handelt es sich um Sputtering Targets mit der Zusammensetzung Al-X-Seltenerd Metall mit gegebenenfalls weiteren Zusätzen an Ni, Co, Cu, Ge. Dabei ist X zumindest ein Element aus der Gruppe (Ta, Nb, Re, Zr, W, Mo, V, Hf, Ti, Cr und Pt) und liegt zwischen 0,1 bis 5 at%. Das jeweilige Seltenerd Metall ist mit 0,1 bis 4 at% enthalten. Targets die Seltenerd Metalle enthalten sind jedoch aufgrund der hohen Kosten und begrenzten Verfügbarkeit weniger vorteilhaft. Weiters ist eine Eignung von mittels solcher Targets abgeschiedenen Schichten aufgrund des geringen Gehalts an Elementen der Gruppe X als Diffusionsbarriere nur eingeschränkt gegeben. Gegenüber der Diffusion von Si (im Kontakt mit Halbleiterwerkstoffen) ist diese Eignung nicht gegeben.

Um gute Sputtereigenschaften (z.B. gleichmäße Sputterrate, Schichthomogenität, gleichmäßige Schichtdicke) zu gewährleisten, müssen Sputtering Targets eine hohe relative Dichte aufweisen. Niedrige relative Dichten vermindern die Beschichtungsrate und können zu erhöhter Partikelbildung beim Sputtern führen, was wiederrum die Eigenschaften der gesputterten Schicht (z.B. schlechte Schichthomogenität) und den Beschichtungsprozess (z.B. hohe Arc-rate, Kurzschlüsse) nachteilig beeinflussen kann.

Mo-AI und W-Al Legierungs Sputtering Targets, die hohe relative Dichten von größer gleich 98% bzw. 99% aufweisen sind in der JP 2000 064033 A und der JP 2000 063971 A beschrieben. Diese Sputtering Targets enthalten jedoch nur zwischen 3 und 10 wt% Mo oder W und weisen zumindest eine Art von intermetallischen Phasen (z.B. MoAl₁₂, MoAl₅, MoAl₄, Mo₃Al₈, MoAl und Mo₃Al bzw. WAl₁₂, WAl₅ und WAl₄) im Gefüge auf.

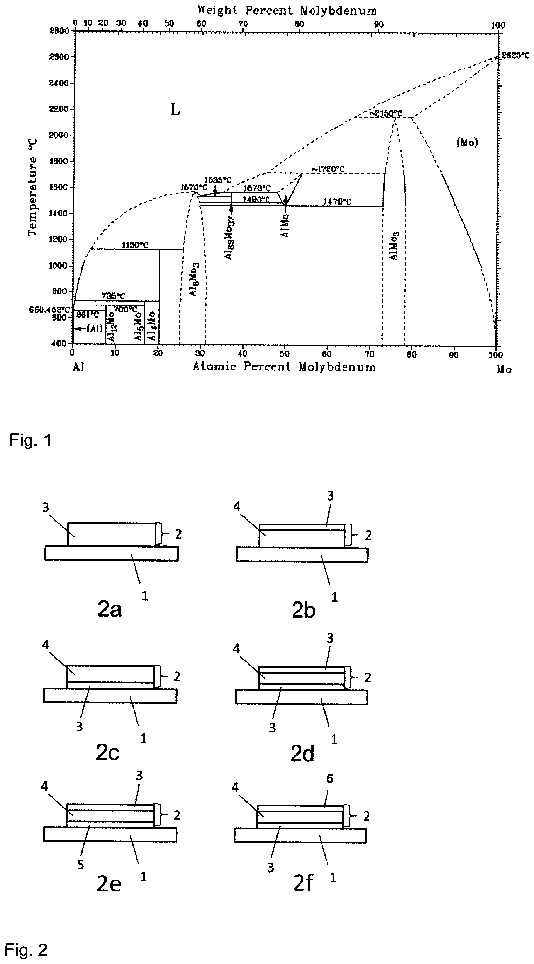

Solche gegebenenfalls im Gefüge derartiger Sputtering Targets enthaltene intermetallische Phasen können jedoch ebenfalls zu erhöhter Partikelbildung beim Sputtern führen und die Eigenschaften der gesputterten Schicht negativ beeinflussen. Mit dem Begriff intermetallische Phasen werden Phasen bezeichnet, die in binären, ternären oder auch Mehrstoffsystemen auftreten und deren Existenzbereich sich nicht bis zu den reinen Komponenten fortsetzt. Sie besitzen häufig von den Kristallstrukturen der reinen Komponenten abweichende Kristallstrukturen sowie Anteile nichtmetallischer Bindungstypen. Intermetallische Phasen sind vor allem durch eine wertigkeitsfremde Zusammensetzung und einen endlichen Homogenitätsbereich, das heißt eine enge stöchiometrische Zusammensetzung gekennzeichnet. Intermetallische Phasen sind häufig spröd, besitzen also geringe Zähigkeit was sich in weiterer Folge nachteilig auf das Sputtering Target auswirken kann. Im binären System Al-Mo gibt es eine große Anzahl möglicher intermetallischer Phasen wie aus dem Phasendiagramm (Figur 1) deutlich ersichtlich ist.

Die Herstellung von Sputtering Targets, die geeignet für die Abscheidung von Metallisierungen für Dünnschichtbauelemente sind, kann sowohl auf schmelzmetallurgischem als auch auf pulvermetallurgischem Weg erfolgen.

Ein Beispiel für die Herstellung von Mo-W Sputtering Targets über die pulvermetallurgische Route ist beispielsweise in der JP 2005 097697 A beschrieben. Darin wird beschrieben, dass die Zugabe von geringen Mengen an AI die Sinterbarkeit von Mo-W Sputtering Targets verbessern kann. Die gezeigten Sputtering Targets haben W-Gehalte von 0,1 bis 70 wt% und Al-Gehalte von 0,1 bis 50 wt%, Rest Mo und werden über das Mischen von Al, W und Mo Pulvern, Pressen und Sintern bei 1300 bis 1600°C hergestellt. Das Gefüge der so hergestellten Sputtering Targets weist Bereiche von Al-Phase zwischen Partikeln von Mo-W Legierung auf. Weiters lösen sich Anteile von Al während des Sinterns in der Mo-W Phase. Der beschriebene Sinterprozess birgt weiters die Gefahr, dass sich bei Sintertemperatur Flüssigphase bildet und eine starke unerwünschte Reaktion zwischen AI und Mo-W entsteht.

Eine weitere Möglichkeit zur Herstellung von Sputtering Targets über eine pulvermetallurgische Route ist in der WO 2008 137689 A2 beschrieben. Darin werden Sputtering Targets über kinetisches Spritzen oder Kaltgasspritzen von Pulvern oder Pulvermischungen aus zumindest einem der Metalle Nb, Ta, W, Mo, Ti, Zr, Cr, V, Mg, Sn, Pb, Al, Zn, Cu, Rh, Ag, Au, Co, Fe, Ru, Re, Ga, In und Sb hergestellt. Die Verwendung solcherart hergestellter Sputtering Targets zur Abscheidung von Rückkontaktschichten oder Barriereschichten ist ebenfalls beschrieben. Eines der beschriebenen Beispiele ist ein über Kaltgasspritzen hergestelltes MoTi Sputtering Target, welches eine zweiphasige Mikrostruktur aufweist. Durch den Vorgang des Kaltgasspritzens bleiben sowohl Mo als auch Ti als elementare Phasen vorliegen, es entsteht keine Legierung durch Interdiffusion. Die beschriebenen binären Systeme haben jedoch den Nachteil, dass nur in begrenztem Maße eine maßgeschneiderte Kombination der erforderlichen Eigenschaften einstellbar ist. So ist ein gleichzeitiges Erreichen von hoher Korrosionsbeständigkeit und Oxidationsbeständigkeit, ausgezeichnetem Ätzverhalten sowie weiter die Erhaltung der Eignung als Diffusionsbarriere nicht oder nur sehr schwer damit möglich.

Auf ähnliche Art hergestellte Sputtering Targets aus Mo-, Ti- oder Ni-Legierungen sind in der WO 2014 073633 A1 beschrieben. Darin finden sich auch Parameter für zum Kaltgasspritzen geeignete Pulver oder Pulvermischungen.

Aus der US 2006/0091397 A1 ist eine Anzeigevorrichtung bekannt, bei der zumindest eine Elektrodenschicht eine Aluminiumlegierung enthaltend mindestens eines oder mehrere Elemente aus der Gruppe Molybdän, Titan und Kohlenstoff enthält. Der empfohlene Gehalt an Molybdän oder Titan in der Aluminiumlegierung liegt im Bereich von 7 - 20 at.%.

Aufgabe der vorliegenden Erfindung ist es also, eine Metallisierung für ein Dünnschichtbauelement zur Verfügung zu stellen, die eine möglichst vorteilhafte Eigenschaftskombination hinsichtlich oben genannter Anforderungen besitzt. Eine solche Metallisierung soll kostengünstig sein und eine optimale Kombination aus hoher Korrosionsbeständigkeit und Oxidationsbeständigkeit, ausgezeichnetem Ätzverhalten sowie eine gute Eignung als Diffusionsbarriere aufweisen. Auch ein Herstellverfahren für eine solche Schicht soll bereitgestellt werden. Weiters ist es Aufgabe der vorliegenden Erfindung, ein Sputtering Target für die beschriebene Anwendung unter Vermeidung der erwähnten Nachteile bereitzustellen. Weiters soll ein geeignetes Herstellverfahren für ein solches Sputtering Target bereitgestellt werden, welches kostengünstig und reproduzierbar die erwünschten Eigenschaften des Sputtering Targets gewährleistet.

Gelöst wird die Aufgabe durch die unabhängigen Ansprüche. Vorteilhafte Ausgestaltungen ergeben sich aus den abhängigen Ansprüchen.

Eine erfindungsgemäße Metallisierung für ein Dünnschichtbauelement ist dadurch gekennzeichnet, dass diese zumindest eine Schicht aus einer Mo-Basislegierung enthaltend AI sowie Ti und übliche Verunreinigungen umfasst, wobei die zumindest eine Schicht aus einer Mo-Basislegierung 10 bis 40 at % Al sowie zwischen 5 bis 15 at% Ti enthält und wobei die Summe der Gehalte von Al und Ti 50 at% nicht überschreitet. Unter üblichen Verunreinigungen werden im Falle einer Metallisierung herstellbedingte Verunreinigungen an Gasen oder begleitenden Elementen bezeichnet, die aus den zur Abscheidung einer solchen Metallisierung verwendeten Sputtering Targets, sowie aus der Sputteratmosphäre stammen können. Die Gehalte an metallischen Begleitelementen korrelieren vorbehaltlich selektiven Sputterns mit deren Gehalten in den verwendeten Sputtering Targets sind aber meist kleiner 1000 µg/g. Die Gehalte an C und Gasen (Ar, O, N) sind abhängig vom Sputterprozess (verwendete Prozessparameter, Vakuum) und können bis zu mehreren at% betragen.

Eine derartige Metallisierung weist eine äußerst vorteilhafte Kombination aus Korrosionsbeständigkeit, Oxidationsbeständigkeit, sowie Ätzverhalten auf.

Das Ätzverhalten wird in einem industriell eingesetzten Gemisch aus Phosphorsäure, Salpetersäure und Essigsäure (PAN-Lösung) bestimmt und ist bei einer erfindungsgemäßen Metallisierung besonders günstig. Durch gezieltes Einstellen des Al- sowie Ti-Gehalts können die Korrosionsbeständigkeit, die Oxidationsbeständigkeit sowie das Ätzverhalten der Metallisierung weiter optimiert werden. Auch die Eignung als Diffusionsbarriere kann über ein Einstellen des Al- sowie Ti- Gehalts gesteuert werden.

Eine erfindungsgemäße Metallisierung weist eine Oxidationsbeständigkeit bis 350°C, in besonders vorteilhaften Ausführungsformen sogar bis 400°C auf.

Unter "Oxidationsbeständigkeit" wird die Beständigkeit der Oberfläche der Metallisierung bei erhöhten Temperaturen unter sauerstoffhaltiger Atmosphäre verstanden. Die Ausbildung einer dünnen, transparenten und schützenden Oxidschicht ist dabei nicht nachteilig bzw. in den meisten Fällen sogar erwünscht, solange damit keine Schädigung der Oberfläche im Sinne einer ungleichmäßigen Oxidation, einer flächigen oder partiellen Verfärbung durch Oxidation und oder einer Veränderung der optischen Eigenschaften verbunden ist. In einem solchen nicht nachteiligen Fall behält die Oberfläche der Metallisierung ihren ursprünglich metallischen Glanz, was durch eine annähernd gleichbleibende Reflektivität der Oberfläche charakterisiert werden kann. Eine solche Ausbildung einer dünnen, transparenten und schützenden Oxidschicht ist hier nicht als Schädigung im Sinne einer geringen Oxidationsbeständigkeit zu verstehen. Wenn es bei einer Auslagerung einer derartigen Metallisierung bei erhöhten Temperaturen unter sauerstoffhaltiger Atmosphäre jedoch zu einer ungleichmäßigen Oxidation, einer Verfärbung der Oberfläche (sowohl flächig als auch partiell) durch Oxidation und oder einer Reduzierung der Reflektivität kommt, wird diese Metallisierung als "nicht oxidationsbeständig" eingestuft.

Unter "Korrosionsbeständigkeit" wird die Beständigkeit der Oberfläche der Metallisierung bei hoher Luftfeuchtigkeit verstanden. Um diese zu testen werden die zu untersuchenden Metallisierungen für 250h und 500h in einer Klimakammer bei 85°C und 85% relativer Luftfeuchtigkeit ausgelagert. Auch hier wird eine Verfärbung der Oberfläche (sowohl flächig als auch partiell) und oder eine Reduzierung der Reflektivität als "nicht korrosionsbeständig" eingestuft.

Sowohl eine mangelnde Oxidationsbeständigkeit als auch eine mangelnde Korrosionsbeständigkeit kann zu einer Einschränkung der Funktionalität einer Metallisierung führen.

Unter "Reflektivität", auch Reflektionsgrad genannt, wird das Verhältnis zwischen reflektiertem und einfallendem Lichtstrom verstanden. Beim reflektierten Lichtstrom wird auch diffus reflektiertes bzw. zurückgestreutes Licht mitberücksichtigt. Es handelt sich um eine fotometrische Größe, bei der das Reflexionsvermögen der Schicht unter Berücksichtigung der wellenlängenabhängigen Empfindlichkeit des menschlichen Auges (bei Tageslicht, photopisches Sehen) charakterisiert wird. Für die Messung des Reflexionsgrades der untersuchten Metallisierungen wurde in erster Näherung der Reflexionsgrad R in % bei 550nm verwendet. Bei dieser Wellenlänge ist die Empfindlichkeit des menschlichen Auges (Helleempfindlichkeit, V-Lambda-Kurve) am höchsten. Die Reflektivität aller untersuchten Metallisierungen wurde direkt auf deren Oberfläche unter Verwendung eines Perkin Elmer Lambda 950 Photospektrometers unter Verwendung der W Geometrie (VW Messaufsatz) gemessen.

Weiters wurden die Oxidationsbeständigkeit und die Korrosionsbeständigkeit der untersuchten Metallisierungen mittels elektrischer Widerstandsmessung überprüft. Die Messung erfolgt jeweils unter Verwendung der 4 Punkt Methode mit einem kommerziell erhältlicher 4 Punkt Messkopf der Firma Jandel und einem Keithley Sourcemeter. Dabei wird ein konstanter Strom von 10mA angelegt und der Spannungsabfall gemessen. Für den Zweck einer möglichst guten Vergleichbarkeit unterschiedlicher Metallisierungen wird dabei der von der Dicke der Metallisierung unabhängige Flächenwiderstand aus dem gemessenen Spannungsabfall berechnet, wobei über 6 Messpunkte pro Probe gemittelt wird. Ein Anstieg des elektrischen Flächenwiderstands der Metallisierung zeigt eine Schädigung durch Oxidation oder Korrosion an. Bei einschichtigen Metallisierungen kann daraus weiter unter Einbeziehen der Schichtdicke der spezifische elektrische Widerstand berechnet werden.

Binäre Vergleichslegierungen für die zumindest eine Schicht aus einer Mo-Basislegierung aus Mo und Ti zeigen ab einem Ti-Gehalt von etwa 25 at% zwar eine sehr gute Oxidationsbeständigkeit, jedoch mit dem großen Nachteil, dass diese nur durch Trockenätzprozesse oder in Ausnahmen in wässrigen Ätzlösungen mit Flusssäure ätz- bzw. strukturierbar sind. Daraus ergeben sich in Folge Einschränkungen in der Fertigung von solche Metallisierungen enthaltenden Dünnschichtbauelementen, beispielsweise in der Kombination mit Cu als elektrisch leitfähige Schicht. Cu lässt sich nur sehr schwer über Trockenätzprozesse ätzen bzw. strukturieren.

Binäre Vergleichslegierungen für die zumindest eine Schicht aus einer Mo-Basislegierung aus Mo und AI zeigen vergleichbar gute Korrosionsbeständigkeiten und Oxidationsbeständigkeiten, zusätzlich aber auch noch ein vorteilhafteres Ätzverhalten. AI hat jedoch den Nachteil, dass es ab Temperaturen von etwa 400°C mit Mo reagiert und intermetallische Phasen mit hohem elektrischem Widerstand bildet. Weiters weisen Schichten aus Mo-Basislegierungen aus Mo und Al nur begrenzte Eignung als Diffusionsbarriere gegen Si auf.

Durch eine kombinierte Zugabe von AI und Ti in die zumindest eine Schicht aus einer Mo-Basislegierung kann unter Reduktion des Ti Gehalts die gute Korrosionsbeständigkeit und Oxidationsbeständigkeit erhalten und teilweise sogar noch verbessert werden, während die Eignung als Diffusionsbarriere erhalten wird und die erfindungsgemäße Metallisierung zusätzlich verbessertes Ätzverhalten in PAN-Lösung zeigt. Die erfindungsgemäße Metallisierung ist somit in industriell gängigen nasschemischen Ätzverfahren gut ätz- bzw. strukturierbar. Zusätzlich kann die unerwünschte Reaktion von Mo und Al weitestgehend unterbunden werden.

Erfindungsgemäß enthält die zumindest eine Schicht aus einer Mo-Basislegierung einer erfindungsgemäßen Metallisierung 10 bis 40 at% Al sowie zwischen 5 bis 15 at% Ti, wobei die Summe der Gehalte von Al und Ti 50 at% nicht überschreitet.

Bei Gehalten von mehr als 15 at% Ti kann es bereits zu einer signifikanten Verringerung der Ätzbarkeit in industriell gängigen nasschemischen Ätzverfahren kommen. Ein bevorzugter Al-Gehalt von 10 at% und mehr beeinflusst das Ätzverhalten bereits sehr positiv. Ein Gehalt von mehr als 40 at% Al erhöht bereits das Risiko einer unerwünschten Reaktion mit Mo bei Temperaturen von etwa 400°C.

Weiter bevorzugt enthält die zumindest eine Schicht aus einer Mo-Basislegierung einer erfindungsgemäße Metallisierung 15 bis 30 at% Al. Gehalte an Al von zwischen 15 bis 30 at% gewährleisten ein weiter optimiertes Ätzverhalten in nasschemischen Ätzverfahren und ausgezeichnete und Korrosionsbeständigkeit und Oxidationsbeständigkeit der erfindungsgemäßen Metallisierung.

Weiter bevorzugt enthält die zumindest eine Schicht aus einer Mo-Basislegierung einer erfindungsgemäßen Metallisierung 5 bis 10 at% Ti. Es hat sich herausgestellt, dass Gehalte von zwischen 5 und 10 at% Ti besonders gut geeignete Metallisierungen in Bezug auf eine Reduktion der Reaktion von Mo und Al bei etwa 400°C bedingen. Weiters wird die gute Eignung als Diffusionsbarriere erhalten und es liegt ein sehr gutes Ätzverhalten (gute Ätzbarkeit) vor.

Noch weiter bevorzugt ist eine Kombination in der zumindest einen Schicht aus einer Mo-Basislegierung einer erfindungsgemäßen Metallisierung aus 15 bis 30 at% Al und 5 bis 10 at% Ti. Diese Kombination führt zu einer weiteren Optimierung der erfindungsgemäßen Metallisierung für ein Dünnschichtbauelement sowohl aus dem Blickwinkel der Fertigung (hohe Oxidationsbeständigkeit, Ätzverhalten) als auch anwendungsseitig (hohe Korrosionsbeständigkeit, geringer elektrischer Widerstand).

Äußerst bevorzugt ist es, wenn die Summe der Gehalte an Al und Ti in der zumindest einen Schicht aus einer Mo-Basislegierung einer erfindungsgemäßen Metallisierung größer gleich 30 at% ist. Die Summe der Gehalte an Al und Ti überschreitet auch dabei nicht 50 at%. Gehalte an Al und Ti in diesem Bereich führen dazu, dass die Oxidationsbeständigkeit dieser Schicht bei Temperaturen bis zu 400°C erhalten bleibt.

In einer bevorzugten Ausführungsform besteht die zumindest eine Schicht aus einer Mo-Basislegierung einer erfindungsgemäßen Metallisierung aus in Summe bis zu 50 at% Al und Ti, Rest Mo und üblichen Verunreinigungen. Weiter bevorzugt ist es wenn die zumindest eine Schicht aus einer Mo-Basislegierung einer erfindungsgemäßen Metallisierung aus 10 bis 40 at% Al und zwischen 5 bis 15 at% Ti, Rest Mo und üblichen Verunreinigungen besteht. Noch weiter bevorzugt ist es wenn die zumindest eine Schicht aus einer Mo-Basislegierung einer erfindungsgemäßen Metallisierung aus 15 bis 30 at% Al und 5 bis 10 at% Ti, Rest Mo und üblichen Verunreinigungen besteht.

Die Dicke der zumindest einen Schicht aus einer Mo-Basislegierung einer erfindungsgemäßen Metallisierung beträgt bevorzugt nicht mehr als 1 µm, weiter bevorzugt nicht mehr als 0,5 µm. Diese Dicken sind für die Anwendung solcher Schichten in entsprechenden Dünnschichtbauelementen besonders gut geeignet. Eine erfindungsgemäße Metallisierung kann neben der zumindest einen Schicht aus einer Mo-Basislegierung noch eine oder mehrere weitere Schichten aus einem oder mehreren anderen Materialien aufweisen.

In Figur 2 ist beispielhaft der Aufbau von Dünnschichtbauelementen, umfassend zumindest eine erfindungsgemäße Metallisierung 2 im Querschnitt dargestellt. Die Metallisierung 2 dient beispielsweise als Leiterbahn oder ist als Elektrode Teil eines Dünnschichttransistors (TFT). Weiters umfassen die dargestellten Dünnschichtbauelemente ein Substrat 1, beispielsweise aus Glas, Kunststoff oder Silizium. Ein solches Substrat kann dabei bereits vorab komplett oder nur teilweise mit ein oder mehreren Schichten aus anderen Materialien beschichtet sein. Weiters enthalten die dargestellten Metallisierungen für Dünnschichtbauelemente zumindest eine Schicht aus einer Mo-Basislegierung 3. Zusätzlich kann zumindest eine Deckschicht (3, 6) und oder eine Zwischenschicht/Diffusionsbarriere (3, 5), sowie zumindest eine metallische Schicht 4 aus Al, Cu, Ag oder Au oder einer Legierung auf Basis dieser Metalle vorgesehen sein.

In einer bevorzugten Ausführungsvariante ist die Metallisierung mehrlagig, insbesondere zweilagig oder dreilagig, aufgebaut. In diesen bevorzugten Ausführungsformen einer erfindungsgemäßen Metallisierung liegt neben der zumindest einen Schicht aus einer Mo-Basislegierung zumindest eine metallische Schicht aus AI, Cu, Ag oder Au oder einer Legierung auf Basis (wobei mit Basis gemeint ist, dass der Bestandteil der Hauptkomponente der Legierung mehr als 50 at% beträgt) eines dieser Metalle vor, wodurch eine noch höhere elektrische Leitfähigkeit der Metallisierung erzielt werden kann.

Die zumindest eine Schicht aus einer Mo-Basislegierung kann dabei auf der dem Substrat abgewandten Seite der metallischen Schicht aus AI, Cu, Ag oder Au oder einer Legierung auf Basis dieser Metalle aufgebracht sein und als Deckschicht dienen, um die Korrosionsbeständigkeit und Oxidationsbeständigkeit der Metallisierung zu gewährleisten. Beispiele einer solchen Metallisierung zeigen die Figuren 2b, 2d und 2e.

Alternativ kann die zumindest eine Schicht aus einer Mo-Basislegierung auf der dem Substrat zugewandten Seite der metallischen Schicht aus Al, Cu, Ag oder Au oder einer Legierung auf Basis dieser Metalle aufgebracht sein und als Zwischenschicht dienen, um beispielsweise Diffusion zwischen dem Substrat und der metallischen Schicht aus Al, Cu, Ag oder Au oder einer Legierung auf Basis dieser Metalle zu verhindern oder zu begrenzen (Diffusionsbarriere). Beispiele einer solchen Metallisierung zeigen die Figuren 2c, 2d und 2f.

Eine weitere bevorzugte Ausführungsform der erfindungsgemäßen Metallisierung sieht sowohl eine Deckschicht, als auch eine Zwischenschicht/Diffusionsbarriere vor, die jeweils aus einer Mo-Basislegierung wie oben beschrieben ausgeführt sein können (Figuren 2d, 2e und 2f). Dabei kann jeweils eine gleichartige 3 oder eine andersartige Deckschicht 6 oder Zwischenschicht/Diffusionsbarriere 5 vorgesehen sein.

Abhängig von den verwendeten Materialien für die Metallisierung, beispielsweise für eine darin enthaltene metallische Schicht 4, und der flächigen Ausdehnung des die entsprechenden Dünnschichtbauelemente enthaltenden elektronischen Geräts wird bevorzugt ein Aufbau wie in den Figuren 2a bis 2d gezeigt verwendet. Weiter bevorzugt ist ein Aufbau wie in Figur 2d gezeigt.

Eine erfindungsgemäße Metallisierung für ein Dünnschichtbauelement ist optimal geeignet für die Verwendung in einer Vielzahl von elektronischen Geräten wie beispielsweise in LCD (Liquid Crystal Display / Flüssigkristall)- oder OLED (organische lichtemittierende Diode)- Bildschirmen, in PC (Personal Computer)- Systemen oder in mobilen Geräten wie Mobiltelefonen, Smartphones, Tablet PCs, PDAs (Personal Digital Assistants), tragbaren Musikplayern, Solarzellen etc. Eine erfindungsgemäße Metallisierung für ein Dünnschichtbauelement wird bevorzugt als Leiterbahn oder Elektrode verwendet.

Bevorzugt wird eine erfindungsgemäße Metallisierung für ein Dünnschichtbauelement in LCD (Liquid Crystal Display / Flüssigkristall)- oder OLED (organische lichtemittierende Diode)- Bildschirmen verwendet.

Eine erfindungsgemäße Metallisierung wird bevorzugt über ein Abscheiden der einen oder mehreren Schichten der Metallisierung mittels bekannter Dünnschicht-Beschichtungstechnologien wie PVD (physical vapour deposition, physikalische Dampfphasenabscheidung) hergestellt.

Dabei enthält ein erfindungsgemäßes Verfahren zur Herstellung einer Metallisierung für ein Dünnschichtbauelement zumindest folgende Schritte:
- Bereitstellen zumindest eines Sputtering Targets
- Abscheiden zumindest einer Schicht aus einer Mo-Basislegierung enthaltend Al, Ti und übliche Verunreinigungen, wobei die zumindest eine Schicht aus einer Mo-Basislegierung 10 bis 40 at% Al sowie zwischen 5 bis 15 at% Ti enthält und wobei die Summe der Gehalte von Al und Ti 50 at% nicht überschreitet
- Strukturieren der Metallisierung mittels zumindest eines photolithographischen Prozesses und mindestens eines anschließenden Ätzschritts

Über ein PVD Verfahren, bevorzugt ist ein Magnetron-Sputterverfahren, wird von dem zumindest einen Sputtering Target zumindest eine Schicht aus einer Mo-Basislegierung enthaltend Al sowie Ti auf zumindest 50% der Oberfläche eines geeigneten Substrats aufgebracht.

Das zumindest eine Sputtering Target kann beispielsweise ein nachfolgend beschriebenes erfindungsgemäßes metallisches Sputtering Target aus einer Mo-Basislegierung enthaltend AI sowie Ti und übliche Verunreinigungen sein. Es ist aber auch möglich andere Sputtering Targets, beispielsweise mehrere Sputtering Targets aus reinen Metallen, in einem erfindungsgemäßen Verfahren zur Herstellung einer Metallisierung für Dünnschichtbauelemente zu verwenden.

Geeignete Substrate sind beispielsweise Glas oder Kunststofffolien. Ein solches Substrat kann dabei bereits vorab komplett oder nur teilweise mit ein oder mehreren Schichten aus anderen Materialien beschichtet sein.

Mittels mindestens eines photolithographischen Prozesses und mindestens eines anschließenden Ätzschritts wird die erfindungsgemäße Metallisierung strukturiert und weiterbearbeitet. Für den mindestens einen Ätzschritt wird bevorzugt ein auch industriell eingesetztes Gemisch aus Phosphorsäure, Salpetersäure und Essigsäure (PAN-Lösung) verwendet, es sind aber auch andere Ätzlösungen verwendbar. Üblicherweise werden solche photolithographischen Prozesse mit anschließendem Ätzschritt wiederholt angewandt, um eine erfindungsgemäße Metallisierung sowie gegebenenfalls auch weitere vorhandene Schichten zu strukturieren.

Ein erfindungsgemäßes Verfahren zur Herstellung einer Metallisierung für ein Dünnschichtbauelement kann weiters einen oder mehrere der folgenden Schritte enthalten:
- Aufbringen einer oder mehrerer organischer Schichten
- Aufbringen eines oder mehrerer TCO (transparente leitfähige Oxide) Schichten
- Aufbringen einer oder mehrerer Schichten aus der Gruppe (Isolationsschicht, Planarisierungsschicht, Pufferschicht)
- Laserbehandlung
- Laminieren mit einer Schutzfolie oder einem Schutzglas
- Assemblieren

Wie oben beschrieben, kann in einem erfindungsgemäßen Verfahren zur Herstellung einer Metallisierung für ein Dünnschichtbauelement ein erfindungsgemäßes Sputtering Target aus einer Mo-Basislegierung enthaltend Al sowie Ti und übliche Verunreinigungen verwendet werden.

Ein erfindungsgemäßes Sputtering Target besteht aus einer Mo-Basislegierung und ist dadurch gekennzeichnet, dass es Al, Ti und übliche Verunreinigungen enthält, wobei es zwischen 10 bis 40 at% Al sowie zwischen 5 bis 15 at% Ti enthält und wobei die Summe der Gehalte von Al und Ti 50 at% nicht überschreitet.

Unter üblichen Verunreinigungen werden herstellbedingte Verunreinigungen an Gasen oder begleitenden Elementen bezeichnet, die aus den verwendeten Rohstoffen stammen. Der Anteil solcher Verunreinigungen in einem erfindungsgemäßen Sputtering Target liegt bevorzugt im Bereich von in Summe unter 2000 µg/g (entspricht ppm) für C und Gase (H, N, O), sowie in Summe unter 500 µg/g für andere Elemente. Geeignete Verfahren zur chemischen Elementanalyse sind bekanntlich abhängig vom Element. Für die chemische Analyse eines erfindungsgemäßen Sputtering Targets wurden ICP-OES (Optische Emissionsspektrometrie mit induktiv gekoppeltem Plasma), RFA (Röntgenfluoreszenzanalyse) und GDMS (Glow Discharge Mass Spectrometry) verwendet.

Bevorzugt weist ein erfindungsgemäßes Sputtering Target einen Anteil an Verunreinigungen im Bereich unter 1000 µg/g für C und Gase (H, N, O), sowie unter 200 µg/g für andere Elemente auf.

Unter Mo-Basislegierung werden Legierungen verstanden, die mindestens 50 at% Mo enthalten.

Mit einem derartigen Sputtering Target kann in optimaler Weise eine oben beschriebene erfindungsgemäße Metallisierung enthaltend zumindest eine Schicht aus entsprechenden Mo-Basislegierungen abgeschieden werden. Die Verwendung eines erfindungsgemäßen Sputtering Targets ist dem Co-Sputtern von mehreren Targets vorzuziehen, da damit eine bessere Schichthomogenität auf großflächigen Substraten gewährleistet werden kann. Zusätzlich sind auch bei einem Sputtering Target diese Gehalte an Al und Ti vorteilhaft, da diese die Korrosionsbeständigkeit des Targets stark erhöhen. Damit wird sowohl die Handhabung eines solchen Sputtering Targets erleichtert als auch dessen Lebensdauer in einer Sputteranlage beim Kontakt mit einem Kühlmedium (z.B. Wasser) verlängert.

Ein erfindungsgemäßes Sputtering Target ist weiter bevorzugt dadurch gekennzeichnet, dass es keine mittels Röntgendiffraktometrie (XRD) nachweisbaren Anteile an intermetallischen Phasen enthält.

Unter dem Begriff intermetallischen Phasen sind hier beispielsweise alle im Phasendiagramm AI-Mo (Figur 1) möglichen intermetallischen Phasen zu verstehen, wobei auch andere binäre oder ternäre Phasen beispielsweise aus dem Dreistoffsystem Mo-Al-Ti hier ebenso verstanden werden. Das Auftreten nachweisbarer Anteile intermetallischer Phasen kann einfach über die Aufnahme eines Röntgendiffraktogramms, in diesem Fall mittels eines D4 Endeavor Diffraktometers von Bruker mit CuKα Strahlung in Bragg-Brentano Geometrie, bestimmt werden. Die übliche Nachweisgrenze liegt bei diesem Verfahren bei einem Phasenanteil von etwa 3 vol%.

Intermetallische Phasen im Gefüge eines erfindungsgemäßen Sputtering Targets sind unter anderem deswegen unerwünscht, da die Bearbeitbarkeit durch die meist hohe Härte und geringe Zähigkeit solcher Phasen eingeschränkt wird. Außerdem können sich intermetallische Phasen nachteilig auf das Sputterverhalten auswirken und beispielsweise Quelle von Partikeln oder Arcing sein. Damit wird auch die Qualität der abgeschiedenen Schicht reduziert.

Weiter bevorzugt enthält ein erfindungsgemäßes Sputtering Target 15 bis 30 at% AI.

Weiter bevorzugt enthält ein erfindungsgemäßes Sputtering Target 5 bis 10at% Ti.

Gehalte an Ti in diesem Bereich haben den zusätzlichen Vorteil, dass eine Herstellung des Targets über Kaltgasspritzen weiter erleichtert wird. Ti ist in Pulverform leicht zu verarbeiten und in sehr guter und reiner Qualität erhältlich.

Noch weiter bevorzugt enthält ein erfindungsgemäßes Sputtering Target eine Kombination aus 15 bis 30 at% Al und 5 bis 10 at% Ti.

Noch weiter bevorzugt enthält ein erfindungsgemäßes Sputtering Target einen summierten Anteil von Al und Ti von größer gleich 30 at%. Die Summe der Gehalte an Al und Ti überschreitet auch dabei nicht 50 at%.

In einer bevorzugten Ausführungsform besteht ein erfindungsgemäßes Sputtering Target aus in Summe bis zu 50 at% Al und Ti, Rest Mo und üblichen Verunreinigungen. Weiter bevorzugt ist es wenn ein erfindungsgemäßes Sputtering Target aus 10 bis 40 at% Al und zwischen 5 bis 15 at% Ti, Rest Mo und üblichen Verunreinigungen besteht. Noch weiter bevorzugt ist es wenn ein erfindungsgemäßes Sputtering Target aus 15 bis 30 at% Al und 5 bis 10 at% Ti, Rest Mo und üblichen Verunreinigungen besteht.

Ein erfindungsgemäßes Sputtering Target hat weiter bevorzugt eine Härte unter 400 HV10.

Wenn das Sputtering Target eine Härte unter 400 HV10 (Vickershärte nach DIN EN ISO 6507-1) aufweist, kann die mechanische Bearbeitbarkeit optimal gewährleistet werden.

Ein erfindungsgemäßes Sputtering Target weist bevorzugt eine relative Dichte von mehr als 95% auf. Besonders Vorteilhaft ist eine relative Dichte von mehr als 97%. Die relative Dichte kann bekanntlich einfach über das archimedische Prinzip mittels Auftriebsverfahren bestimmt werden.

Je höher die relative Dichte des Sputtering Targets, umso vorteilhafter sind dessen Eigenschaften in Bezug auf das Sputterverhalten. Sputtering Targets mit geringer relativer Dichte weisen einen höheren Anteil an Poren auf, die eine Quelle von Verunreinigungen und Partikeln in der Schicht sein können. Weiters ist die Sputterrate von Material mit geringerer Dichte niedriger als von Material mit hoher Dichte.

Durch Einbau eines erfindungsgemäßen Sputtering Targets in unterschiedlichen Beschichtungsanlagen, sowie für die Beschichtung von Substraten unterschiedlicher Geometrie werden verschiedene geometrische Anforderungen an ein erfindungsgemäßes Sputtering Target gestellt. So kann ein solches in Form eines Flachtargets, beispielsweise als Platte oder Scheibe, als Stange, als Rohrtarget oder als anderer komplex geformter Körper vorliegen.

Erfindungsgemäße Sputtering Targets aus einer Mo-Basislegierung können mittels eines erfindungsgemäßen Verfahrens hergestellt werden. Ein solches erfindungsgemäßes Verfahren zur Herstellung eines Sputtering Targets aus einer Mo-Basislegierung enthält zumindest folgende Schritte:
- Bereitstellen einer Pulvermischung enthaltend Mo, sowie AI und Ti
- Kaltgasspritzen (CGS / cold gas spraying) der Pulvermischung auf ein geeignetes Trägermaterial.

Die bereitgestellte Pulvermischung kann sowohl reine Pulver als auch bereits vorlegierte Pulver enthalten. Verwendete Pulver können sowohl separat als auch gemeinsam gefördert werden. Die Pulvermischung kann also bereits vor, als auch erst in der verwendeten Anlage für das Kaltgasspritzen, beispielsweise in einer entsprechenden Düse, bereitgestellt werden. Über eine separate Förderung einzelner Pulver der Pulvermischung kann der Prozess des Kaltgasspritzens besonders gut gesteuert werden.

Der Eintrag an thermischer Energie während der Herstellung des Sputtering Targets muss so gering sein, dass sich keine intermetallischen Phasen ausbilden können. Bei alternativen Herstellverfahren wie Heißpressen oder heißisostatischem Pressen kann aufgrund der hohen Prozesstemperaturen und Haltezeiten die Bildung von intermetallischen Phasen nicht oder nur unvollständig vermieden werden. Ein mit solchen Verfahren hergestellter Rohling weist damit meist eine zu hohe Härte und geringe Zähigkeit auf und ist nur schwer mechanisch zu bearbeiten. Weiters können intermetallische Phasen im Gefüge eines Sputtering Targets zu einem nachteiligen Sputterverhalten des Targets führen.

Geeignete Trägermaterialien, die in einem erfindungsgemäßen Verfahren verwendet werden, können beispielsweise platten- oder rohrförmig sein und aus Stahl, Ti, Cu, Al oder einer Legierung auf Basis eines dieser Metalle gefertigt sein.

Bevorzugt enthält ein erfindungsgemäßes Verfahren weiters folgenden Schritt:
- Aufbringen einer metallischen Haftschicht

Um die Haftung der mittels Kaltgasspritzen aufgebrachten Pulvermischung auf dem Trägermaterial zu verbessern, kann zusätzlich eine metallische Haftschicht, zum Beispiel Al, auf das Trägermaterial aufgebracht werden. Eine solche Haftschicht ist besonders für Trägermaterialien mit höherer Härte (Ti, Stahl) vorteilhaft. Diese Haftschicht kann beispielsweise ebenso über Kaltgasspritzen aufgebracht werden, es sind aber auch andere Möglichkeiten (z.B. andere Spritzverfahren, Slurrybeschichtung, Plattieren, PVD Verfahren, CVD (chemical vapor deposition) Verfahren) denkbar.

Ein erfindungsgemäßes Verfahren zur Herstellung eines Sputtering Targets kann weiters einen oder mehrere der folgenden Schritte, in an die jeweiligen Anforderungen angepasster Reihenfolge, enthalten:
- Mechanische Bearbeitung
- Wärmebehandlungsschritt
- Umformschritt
- Auflöten (Bonding) auf ein oder mehrere Stützelemente

Eine entsprechende mechanische Bearbeitung kann beispielsweise einen oder mehrere Dreh-, Fräs- oder Schleifprozesse enthalten, bei denen die gewünschten Abmessungen des Sputtering Targets und oder dessen Oberflächenrauigkeit eingestellt werden können.

Bei einem entsprechenden Wärmebehandlungsschritt können beispielsweise im Sputtering Target verbliebene Spannungen abgebaut werden. Weiters ist auch eine Anregung von Diffusionsvorgängen, die zu weiter verbesserter Haftung auf dem Trägermaterial führen, vorstellbar.

Ein entsprechender Umformschritt kann beispielsweise bei flächigen Sputtering Targets (Flachtargets) über Walzen oder bei rohrförmigen Sputtering Targets über Strangpressen verwirklicht werden. Ein solcher Umformschritt kann zu einer weiteren Erhöhung der Dichte sowie zu weiter optimiertem Gefüge und in Folge zu weiter verbesserten Eigenschaften des Sputtering Targets führen.

Ein erfindungsgemäßes Sputtering Target kann auf ein oder mehrere Stützelemente aufgelötet werden (Bonding). Dazu können entsprechende Stützelemente in der Form von Platten sowie Rohren oder Rohrsegmenten verwendet werden. Bevorzugt wird dafür Lotmaterial mit niedrigem Schmelzpunkt, beispielsweise In oder eine In-Legierung verwendet.

### Ausführungsbeispiele

### Beispiel 1:

Im vorliegenden Ausführungsbeispiel wurde ein Dünnschichtbauelement wie in Figur 2 a gezeigt aufgebaut.

Im Rahmen der Versuchsserien wurden unterschiedliche Metallisierungen enthaltend je eine Schicht aus einer Mo-Basislegierung mit unterschiedlicher chemischer Zusammensetzung gefertigt. Die Schichten wurden von Sputtering Targets aus reinem Molybdän, reinem Aluminium, reinem Titan und Mo-Basislegierungen mit 10at% Ti und 20 at% Ti abgeschieden. Die Schichten aus Mo-Basislegierungen enthaltend AI sowie Ti wurden über Co-Sputtern von 2 oder 3 unterschiedlichen Sputtering Targets hergestellt. Dabei wurde die chemische Zusammensetzung der Schicht über die Kombination der unterschiedlichen Sputtering Targets und der Sputterleistung an den Sputtering Targets variiert. Die chemische Zusammensetzung der hergestellten Schichten ist Tabelle 1 zu entnehmen.

Um die Eignung der Schichten aus Mo-Basislegierungen als Deckschicht zu bestimmen wurden Glassubstrate (Corning Eagle XG®, 50x50x0,7 mm³) mit den Schichten aus Mo-Basislegierungen beschichtet und anschließend deren Korrosionsbeständigkeit und Oxidationsbeständigkeit getestet. Für den Test auf Oxidationsbeständigkeit wurden die Schichten bei 330°C 1h an Luft geglüht. Um die Korrosionsbeständigkeit zu testen wurden die Proben für 250h und 500h in einer Klimakammer bei 85°C und 85% relativer Luftfeuchtigkeit ausgelagert. Reines Mo, MoTi10 und MoTi20 dienten als Referenzmaterialien.

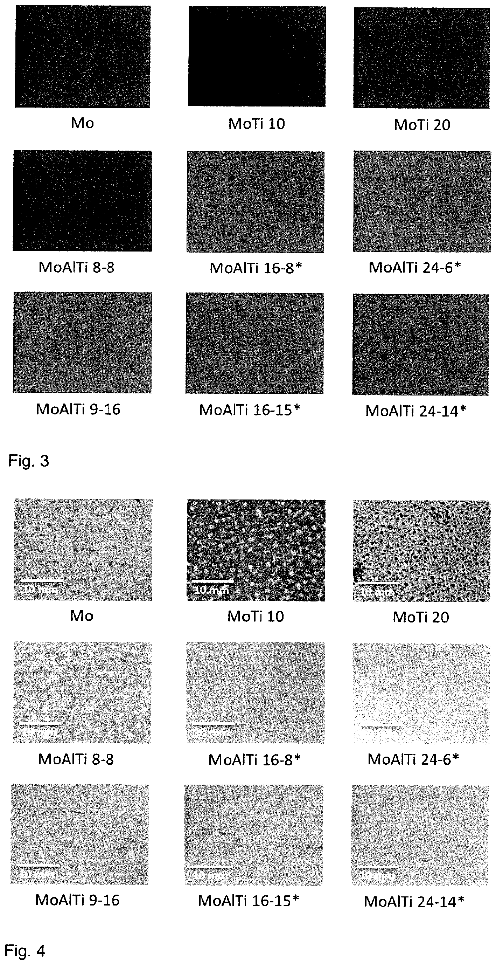

Figur 3 zeigt die unterschiedlichen Schichten nach dem Test auf Oxidationsbeständigkeit. Die Referenzmaterialien und die Schicht aus der Mo-Basislegierung mit 8 at% Al und 8 at% Ti weisen eine stark verfärbte Oberfläche und somit geringe Oxidationsbeständigkeit auf.

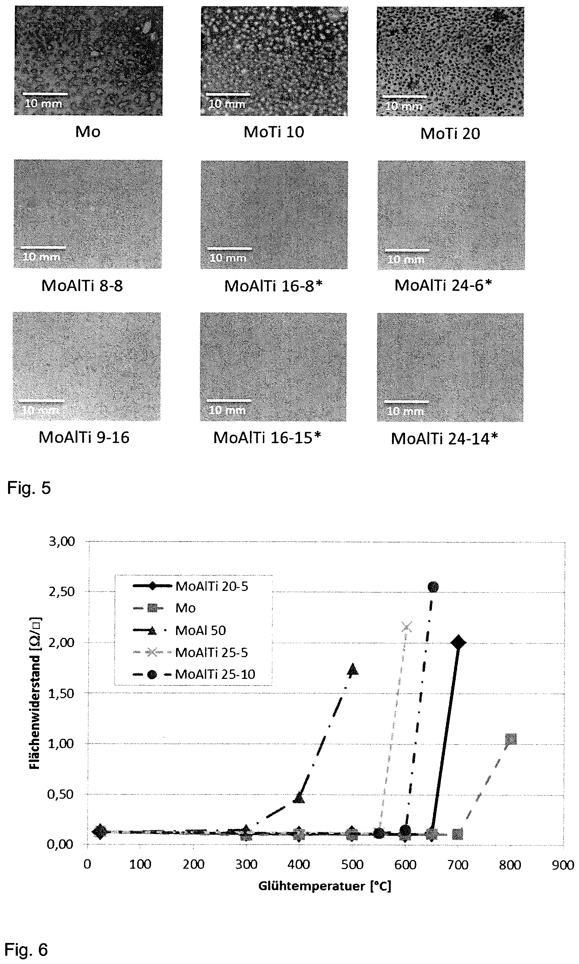

Figur 4 zeigt die unterschiedlichen Schichten nach dem Test auf Korrosionsbeständigkeit. Nach 250h in der Klimakammer weisen sowohl die Referenzmaterialien und die Schicht aus der Mo-Basislegierung mit 8 at% Al und 8 at% Ti und zusätzlich die Schicht aus der Mo-Basislegierung mit 9 at% Al und 16 at% Ti Korrosionsschäden auf. Das Ergebnis des 500h Klimakammertests (siehe Figur 5) ist mit dem Ergebnis des 250h Tests vergleichbar.

Die Reflektivität aller Schichten wurde direkt auf die Oberfläche der Schichten unter Verwendung eines Perkin Elmer Lambda 950 Photospektrometers unter Verwendung der W Geometrie (VW Messaufsatz) bei Wellenlängen von 250 bis 850nm gemessen. Die Ergebnisse sind ebenfalls in Tabelle 1 zusammengefasst. Je größer der Unterschied des Messwertes im Vergleich zum Ausgangszustand ("wie beschichtet"), desto stärker ist die Schädigung der Oberfläche. Bereits eine Abweichung von mehr als 3% kann vom menschlichen Auge wahrgenommen werden. Als Grenze für eine mögliche Anwendung wurde in diesem Experiment eine Verringerung der Reflektivität gegenüber dem Ausgangszustand von 5% festgelegt.

**Tabelle 1:**

| * markiert besonders vorteilhafte erfindungsgemäße Ausführungsformen | | | | |
|---|---|---|---|---|
| Zusammensetzung der Schicht (at.%) | Reflektivität bei 550nm (%) | | | |
| | wie beschichtet | 330°C, 1 h, Luft | 250h, 85°C, 85% rF | 500h, 85°C, 85% rF |
| Mo | 59,6 | 41,8 | 34,1 | 5,5 |
| MoTi 10 | 57,4 | 28,3 | 14,0 | 16,4 |
| MoTi 20 | 56,6 | 38,3 | 40,2 | 29,7 |
| MoAlTi 8-8 | 57,1 | 36,4 | 27,9 | 12,9 |
| MoAlTi 16-8* | 56,4 | 53,1 | 57,2 | 55,5 |
| MoAlTi 24-6* | 55,8 | 53,8 | 56,5 | 55,9 |
| MoAlTi 9-16 | 56,7 | 51,4 | 54,1 | 51,0 |
| MoAlTi 16-15* | 56,2 | 52,9 | 56,9 | 56,0 |
| MoAlTi 24-14* | 55,3 | 53,3 | 56,3 | 55,2 |

Der spezifische elektrische Widerstand der Schichten und der Referenzmaterialien wurde am Ausgangszustand, nach dem Test auf Oxidationsbeständigkeit sowie dem Test auf Korrosionsbeständigkeit gemessen. Der Aufbau nach Figur 2 a wurde gewählt um eine möglichst genaue Messung des spezifischen elektrischen Widerstandes gewährleisten zu können. Die abgeschiedene Schichtdicke betrug jeweils 300 nm. Die Messung erfolgte unter Verwendung der 4 Punkt Methode mit einem kommerziell erhältlichen 4 Punkt Messkopf der Firma Jandel und einem Keithley Sourcemeter. Dabei wurde ein konstanter Strom von 10mA angelegt und der Spannungsabfall gemessen. Daraus wurde über die Schichtdicke der spezifische elektrische Widerstand berechnet. Es wurde über 6 Messpunkte pro Probe gemittelt. Die Ergebnisse sind in Tabelle 2 zusammengefasst. Durch den Test auf Oxidationsbeständigkeit wurde die Leitfähigkeit (der spezifische elektrische Widerstand) der untersuchten Schichten nicht signifikant beeinflusst. Die stark korrodierten Proben (Test auf Korrosionsbeständigkeit) wiesen jedoch inhomogene Messwerte bis hin zu isolierenden Oberflächenstellen (keine Messung möglich) auf. Die Proben mit den hohen Gehalten an Al und Ti zeigen eine gegenüber den Referenzmaterialien deutlich verbesserte Korrosionsbeständigkeit und Oxidationsbeständigkeit.

**Tabelle 2:**

| * markiert besonders vorteilhafte erfindungsgemäße Ausführungsformen | | | | |
|---|---|---|---|---|
| Zusammensetzung der Schicht (at.%) | spezifischer elektrischer Widerstand [µ Ohm cm] | | | |
| | wie beschichtet | 330°C, 1h, Luft | 250h, 85°C, 85% rF | 500h, 85°C, 85% rF |
| Mo | 12 | 13 | inhomogen | inhomogen |
| MoTi 10 | 28 | 28 | inhomogen | inhomogen |
| MoTi 20 | 36 | 41 | inhomogen | inhomogen |
| MoAlTi 8-8 | 100 | 103 | 109 | inhomogen |
| MoAlTi 16-8* | 121 | 122 | 145 | 147 |
| MoAlTi 24-6* | 149 | 152 | 152 | 148 |
| MoAlTi 9-16 | 93 | 96 | 85 | 85 |
| MoAlTi 16-15* | 124 | 126 | 113 | 111 |
| MoAlTi 24-14* | 152 | 155 | 148 | 148 |

Zur Untersuchung des Ätzverhaltens wurden die Schichten mit einer Dicke von jeweils 300nm in einer gerührten PAN Lösung mit 66 wt% Phosphorsäure, 10 wt% Essigsäure, 5 wt% Salpetersäure und Wasser (Rest) bei 40°C geätzt. Die verwendete Phosphorsäure besteht dabei aus einer 85%igen wässrigen Lösung, die Salpetersäure aus einer 65%igen wässrigen Lösung, die Essigsäure ist rein (100%). Zur Bestimmung der Ätzrate wurden die Proben jeweils für 5 Sekunden in die Ätzlösung getaucht und anschließend mit deionisiertem Wasser gespült und getrocknet. Die trockenen Proben wurden anschließend auf einer Präzisionswaage gewogen. Diese Schritte wurden solange wiederholt bis die gesamte Schicht aufgelöst war. Aus der Massenabnahme über der Ätzzeit wurde die Ätzrate (Nassätzrate) berechnet. Die Ergebnisse sind in Tabelle 3 zusammengefasst. Alle untersuchten Schichten lassen sich in PAN Lösung ätzen, wobei die Ätzrate mit steigendem Ti Gehalt stark abnimmt.

**Tabelle 3:**

| * markiert besonders vorteilhafte erfindungsgemäße Ausführungsformen | |
|---|---|
| Zusammensetzung der Schicht (at.%) | Nassätzrate (nm/min) |
| Mo | 1550 |
| MoTi 10 | 1443 |
| MoTi 20 | 208 |
| MoAlTi 8-8 | 1154 |
| MoAlTi 16-8* | 842 |
| MoAlTi 24-6* | 611 |
| MoAlTi 9-16 | 180 |
| MoAlTi 16-15* | 165 |
| MoAlTi 24-14* | 140 |

### Beispiel 2:

Im Rahmen der Versuchsserien wurden eine Metallisierungen enthaltend Schichten aus Mo-Basislegierungen mit 20 at% AI sowie 5 at% Ti (MoAlTi 20-5), 25 at% Al sowie 5 at% Ti (MoAlTi 25-5) und 25 at% AI sowie 10 at% Ti (MoAlTi 25-10) gefertigt. Die Schichten wurden von Sputtering Targets mit den entsprechenden chemischen Zusammensetzungen abgeschieden. Um die Eignung der Schichten aus den Mo-Basislegierungen als Diffusionsbarriere gegen Si zu bestimmen wurden Si-Wafer (Durchmesser 3 Zoll, Dicke 380 µm) mit den entsprechenden Schichten aus den Mo-Basislegierungen (Schicht 3, siehe Figur 2 c) und jeweils Cu Schichten (metallische Schicht 4, siehe Figur 2c) beschichtet. Der Aufbau nach Figur 2c wurde gewählt, da zusätzliche Schichten die Sicht auf die Cu Schichten versperren würden. Die Schichtdicke betrug dabei 50 nm für die Schichten aus den Mo-Basislegierungen und 200 nm für die Cu-Schichten.

Um die Eignung der Schichten aus den Mo-Basislegierungen als Diffusionsbarriere zu prüfen, wurden die Metallisierungen im Vakuum (10⁻⁵ mbar) bei unterschiedlichen Temperaturen für 30min geglüht. Als Referenzmaterialien dienten reines Mo und eine Mo- Legierung mit 50 at% AI.

Die Eignung der Schicht als Diffusionsbarriere ist nicht mehr gegeben, wenn die Oberfläche der Cu-Schicht silbrige Verfärbungen aufweist und der elektrische Flächenwiderstand signifikant ansteigt. Dies ist ein Indiz dafür, dass sich intermetallische Phasen aus Cu und Si gebildet haben. Der elektrische Flächenwiderstand wurde nach dem Beschichten (Ausgangszustand) und nach den Glühbehandlungen berechnet/gemessen. Die Messung erfolgte unter Verwendung der 4 Punkt Methode (kommerziell erhältlicher 4 Punkt Messkopf). Die Ergebnisse sind in Figur 6 zusammengefasst.

Die Schicht aus der Mo-Basislegierung mit 20 at% AI sowie 5 at% Ti verliert ihre Eignung als Diffusionsbarriere gegen Silizium bei ca. 650°C. Dies ist eine nur unwesentlich niedrigere Temperatur als bei der Referenzprobe mit Mo-Schicht (700°C). Bei höherem Al-Gehalt in der Schicht wie beispielsweise bei der Mo-Legierung mit 50 at% AI geht die Eignung als Diffusionsbarriere bereits bei 300°C verloren (Figur 6). Durch eine Erhöhung des Ti Gehaltes in den Schichten aus Mo-Basislegierungen kann die Eignung als Diffusionsbarriere bei höheren Al Gehalten in der Legierung weiter verbessert werden (Vergleich von MoAlTi 25-5 und MoAlTi 25-10 in Figur 6). Diese Schichten erfüllen somit in optimaler Weise die für die Anwendung geforderte Eignung als Diffusionsbarriere mit den beschriebenen Vorteilen der erhöhten Korrosionsbeständigkeit und Oxidationsbeständigkeit (siehe Beispiel 1).

### Beispiel 3:

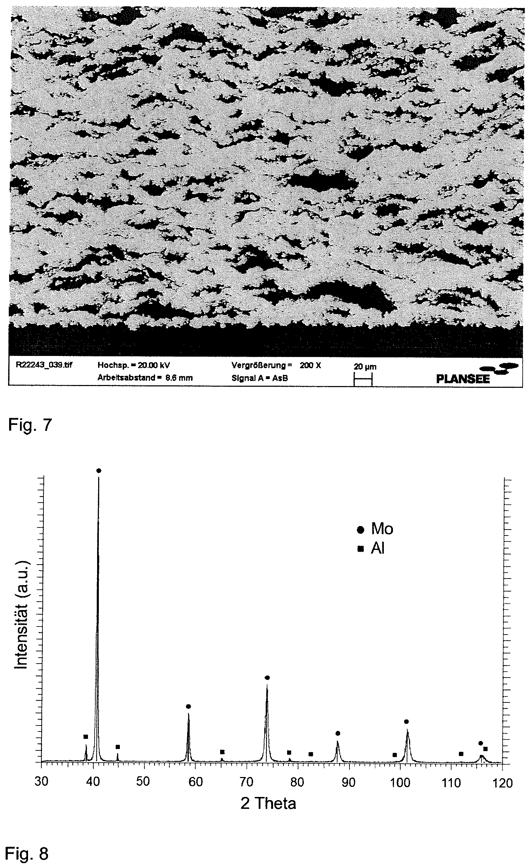

Handelsübliche fürs Kaltgasspritzen geeignete Mo, Al und Ti Pulver wurden mittels Kaltgasspritzen auf ein AI Rohr als Trägermaterial gespritzt. Die Pulver wurden dabei aus separaten Behältern gefördert. Die chemische Zusammensetzung wurde über die Fördergeschwindigkeiten der einzelnen Pulver eingestellt. Das Gefüge des so hergestellten Sputtering Targets mit 20 at% Al und 5 at% Ti ist in Figur 7 im Querschliff (Rasterelektronenmikroskopische (REM) Aufnahme) gezeigt. Das Gefüge ist typisch für ein über Kaltgasspritzen Spritzen hergestelltes Material mit länglichen Körnern, deren längere Achse parallel zur Oberfläche des Trägermaterials angeordnet ist. Durch das Kaltgasspritzen bilden sich bei der Herstellung des Sputtering Targets keine intermetallischen Phasen aus, wie das Röntgendiffraktogramm in Figur 8 zeigt. Dieses wurde mittels eines D4 Endeavor Diffraktometers von Bruker mit CuKα Strahlung in Bragg-Brentano Geometrie aufgenommen.

### Beispiel 4:

Im vorliegenden Ausführungsbeispiel wurde ein Dünnschichtbauelement wie in Figur 2 a gezeigt aufgebaut.

Im Rahmen der Versuchsserien wurden unterschiedliche Metallisierungen enthaltend je eine Schicht aus einer Mo-Basislegierung mit unterschiedlicher chemischer Zusammensetzung gefertigt. Die Schichten aus Mo-Basislegierungen enthaltend AI sowie Ti wurden von Sputtering Targets mit den entsprechenden chemischen Zusammensetzungen abgeschieden. Es wurden Schichten aus Mo-Basislegierungen mit 20 at% Al sowie 5 at% Ti (MoAlTi 20-5), 20 at% Al sowie 10 at% Ti (MoAlTi 20-10), 25 at% Al sowie 5 at% Ti (MoAlTi 25-5) und 25 at% Al sowie 10 at% Ti (MoAlTi 25-10) abgeschieden.

Um die Eignung der Schichten aus Mo-Basislegierungen als Deckschicht zu bestimmen, wurden Glassubstrate (Corning Eagle XG®, 50x50x0,7 mm³) mit den Schichten aus Mo-Basislegierungen beschichtet und anschließend deren Oxidationsbeständigkeit getestet. Für den Test auf Oxidationsbeständigkeit wurden die Schichten bei 400°C 1h an Luft geglüht.

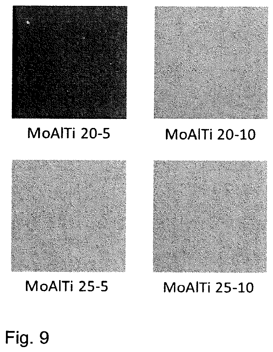

Figur 9 zeigt die unterschiedlichen Schichten nach dem Test. Die Schichten aus Mo-Basislegierungen mit einem summierten Anteil von Al und Ti von größer gleich 30 at% zeigen keine Verfärbungen der Oberfläche und sind somit bis 400°C oxidationsbeständig.

Von den Figuren zeigen:
- Figur 1:: Phasendiagramm des Systems AI-Mo (Quelle: ASM International's Binary Alloy Phase Diagrams, Second Edition).
- Figur 2:: Möglicher Aufbau von Dünnschichtbauelementen, umfassend zumindest eine erfindungsgemäße Metallisierung im Querschnitt. 1: Substrat; 2: Metallisierung; 3: Schicht aus einer Mo-Basislegierung; 4: Schicht aus Al, Cu, Ag oder Au oder einer Legierung auf Basis dieser Metalle; 5: andersartige Zwischenschicht/Diffusionsbarriere; 6: andersartige Deckschicht
- Figur 3:: Oberflächenaufnahme der untersuchten Schichten nach dem Test auf Oxidationsbeständigkeit (Glühung bei 330°C an Luft für 1h). * markiert besonders vorteilhafte erfindungsgemäße Ausführungsformen.
- Figur 4:: Oberflächenaufnahmen der untersuchten Schichten nach dem Test auf Korrosionsbeständigkeit (250h in der Klimakammer bei 85°C und 85% relativer Luftfeuchtigkeit). * markiert besonders vorteilhafte erfindungsgemäße Ausführungsformen.
- Figur 5:: Oberflächenaufnahmen der untersuchten Schichten nach dem Test auf Korrosionsbeständigkeit (500h in der Klimakammer bei 85°C und 85% relativer Luftfeuchtigkeit). * markiert besonders vorteilhafte erfindungsgemäße Ausführungsformen.
- Figur 6:: Flächenwiderstand der geglühten Proben (50 nm Schicht aus Mo oder Mo-Basislegierung und 200 nm Cu-Schicht auf Siliziumsubstrat) vs. Glühtemperatur.
- Figur 7:: Rasterelektronenmikroskopische Aufnahme eines Sputtering Targets mit 20 at% AI und 5 at% Ti. Dunkle Bereiche unterer Bildrand: Trägermaterial aus Al. Dunkle Bereiche im Gefüge: AI und Ti. Helle Bereiche: Mo.
- Figur 8:: Röntgendiffraktogramm eines Sputtering Targets mit 20 at% Al und 5 at% Ti. Keine Anteile intermetallischer Phasen nachweisbar.
- Figur 9:: Oberflächenaufnahmen der untersuchten Schichten nach dem Test auf Oxidationsbeständigkeit (Glühung bei 400°C an Luft für 1h).

## Patentansprüche

1. Metallisierung für ein Dünnschichtbauelement **dadurch gekennzeichnet, dass** diese zumindest eine Schicht aus einer Mo-Basislegierung enthaltend Al, Ti und übliche Verunreinigungen umfasst, wobei die zumindest eine Schicht aus einer Mo-Basislegierung 10 bis 40 at% Al sowie zwischen 5 bis 15 at% Ti enthält und wobei die Summe der Gehalte von Al und Ti 50 at% nicht überschreitet.

2. Metallisierung nach Anspruch 1, **dadurch gekennzeichnet, dass** diese eine Oxidationsbeständigkeit bis 350°C, in besonders vorteilhaften Ausführungsformen bis 400°C aufweist.

3. Metallisierung nach Anspruch 1 oder 2, **dadurch gekennzeichnet, dass** die zumindest eine Schicht aus einer Mo-Basislegierung 15 bis 30 at% Al enthält.

4. Metallisierung nach einem der vorangehenden Ansprüche, **dadurch gekennzeichnet, dass** die zumindest eine Schicht aus einer Mo-Basislegierung 5 bis 10 at% Ti enthält.

5. Metallisierung nach einem der vorangehenden Ansprüche, **dadurch gekennzeichnet, dass** diese zusätzlich zumindest eine metallische Schicht aus Al, Cu, Ag oder Au oder einer Legierung auf Basis eines dieser Metalle enthält.

6. Metallisierung nach Anspruch 5, **dadurch gekennzeichnet, dass** die zumindest eine Schicht aus einer Mo-Basislegierung auf der dem Substrat abgewandten Seite der metallischen Schicht aus Al, Cu, Ag oder Au oder einer Legierung auf Basis dieser Metalle aufgebracht ist.

7. Verwendung einer Metallisierung nach einem der vorangehenden Ansprüche als Leiterbahn oder Elektrode.

8. Verfahren zur Herstellung einer Metallisierung für ein Dünnschichtbauelement, **dadurch gekennzeichnet, dass** es zumindest folgende Schritte enthält:
- Bereitstellen zumindest eines Sputtering Targets
- Abscheiden zumindest einer Schicht aus einer Mo-Basislegierung enthaltend Al, Ti und übliche Verunreinigungen, wobei die zumindest eine Schicht aus einer Mo-Basislegierung 10 bis 40 at% Al sowie zwischen 5 bis 15 at% Ti enthält und wobei die Summe der Gehalte von Al und Ti 50 at% nicht überschreitet
- Strukturieren der Metallisierung mittels zumindest eines photolithographischen Prozesses und mindestens eines anschließenden Ätzschritts

9. Sputtering Target aus einer Mo-Basislegierung **dadurch gekennzeichnet, dass** es AI,Ti und übliche Verunreinigungen enthält, wobei es zwischen 10 bis 40 at% Al sowie zwischen 5 bis 15 at% Ti enthält und wobei die Summe der Gehalte von Al und Ti 50 at% nicht überschreitet.

10. Sputtering Target nach Anspruch 9, **dadurch gekennzeichnet, dass** es keine mittels Röntgendiffraktometrie (XRD) nachweisbaren Anteile an intermetallischen Phasen enthält.

11. Sputtering Target nach Anspruch 9 oder 10, **dadurch gekennzeichnet, dass** es 15 bis 30 at% Al enthält.

12. Sputtering Target nach einem der Ansprüche 9 bis 11, **dadurch gekennzeichnet, dass** es 5 bis 10 at% Ti enthält.

13. Sputtering Target nach einem der Ansprüche 9 bis 12, **dadurch gekennzeichnet, dass** seine Härte unter 400 HV10 liegt.

14. Verfahren zur Herstellung eines Sputtering Targets gemäß einem der Ansprüche 9 bis 13, **dadurch gekennzeichnet, dass** es zumindest folgende Schritte enthält:
- Bereitstellen einer Pulvermischung enthaltend Mo, Al und Ti
- Kaltgasspritzen (CGS - cold gas spraying) der Pulvermischung auf ein geeignetes Trägermaterial.

## Claims

1. Metallization for a thin-film component, **characterized in that** the metallization comprises at least one layer composed of an Mo-based alloy containing Al and Ti and usual impurities, wherein the at least one layer composed of an Mo-based alloy contains from 10 to 40 at% of Al and between 5 to 15 at% of Ti, with the sum of the contents of Al and Ti not exceeding 50 at%.

2. Metallization according to Claim 1, **characterized in that** the metallization is oxidation-resistant up to 350°C, in particularly advantageous embodiments up to 400°C.

3. Metallization according to claim 1 or claim 2, **characterized in that** the at least one layer composed of an Mo-based alloy contains from 15 to 30 at% of Al.

4. Metallization according to any of the preceding claims, **characterized in that** the at least one layer composed of an Mo-based alloy contains from 5 to 10 at% of Ti.

5. Metallization according to any of the preceding claims, **characterized in that** the metallization additionally contains at least one metallic layer composed of Al, Cu, Ag or Au or an alloy based on one of these metals.

6. Metallization according to Claim 5, **characterized in that** the at least one layer composed of an Mo-based alloy has been applied to the side of the metallic layer composed of Al, Cu, Ag or Au or an alloy based on these metals facing away from the substrate.

7. Use of a metallization according to any of the preceding claims as conductor track or electrode.

8. Process for producing a metallization for a thin-film component, **characterized in that** it comprises at least the following steps:
- provision of at least one sputtering target
- deposition of at least one layer of an Mo-based alloy containing Al and Ti and usual impurities, wherein the at least one layer composed of an Mo-based alloy contains from 10 to 40 at% of Al and between 5 to 15 at% of Ti, with the sum of the contents of Al and Ti not exceeding 50 at%.
- structuring of the metallization by means of at least one photolithographic process and at least one subsequent etching step.

9. Sputtering target composed of an Mo-based alloy, **characterized in that** it contains Al and Ti and usual impurities, wherein it contains from 10 to 40 at% of Al and between 5 to 15 at% of Ti, with the sum of the contents of Al and Ti not exceeding 50 at%.

10. Sputtering target according to Claim 9, **characterized in that** it does not contain any proportions of intermetallic phases which are detectable by means of X-ray diffraction (XRD).

11. Sputtering target according to any of Claims 9 or 10, **characterized in that** it contains from 15 to 30 at% of Al.

12. Sputtering target according to any of Claims 9 to 11, **characterized in that** it contains from 5 to 10 at% of Ti.

13. Sputtering target according to any of Claims 3 to 12, **characterized in that** its hardness is below 400 HV10.

14. Process for producing a sputtering target according to any of Claims 9 to 13, **characterized in that** it comprises at least the following steps:
- provision of a powder mixture containing Mo, Al and Ti
- cold gas spraying (CGS) of the powder mixture onto a suitable support material.

## Revendications

1. Métallisation pour un composant en couche mince, **caractérisée en ce qu'**elle comprend au moins une couche composée d'un alliage de base de Mo contenant Al, Ti et des impuretés habituelles, l'au moins une couche composée d'un alliage de base de Mo contenant 10 à 40 % en atomes d'Al ainsi que 5 à 15 % en atomes de Ti et la somme des teneurs en Al et Ti ne dépassant pas 50 % en atomes.

2. Métallisation selon la revendication 1, **caractérisée en ce que** celle-ci présente une résistance à l'oxydation jusqu'à 350 °C, dans des modes de réalisation particulièrement avantageux jusqu'à 400 °C.

3. Métallisation selon la revendication 1 ou 2, **caractérisée en ce que** l'au moins une couche composée d'un alliage de base de Mo contient 15 à 30 % en atomes d'Al.

4. Métallisation selon l'une quelconque des revendications précédentes, **caractérisée en ce que** l'au moins une couche composée d'un alliage de base de Mo contient 5 à 10 % en atomes de Ti.

5. Métallisation selon l'une quelconque des revendications précédentes, **caractérisée en ce que** celle-ci contient de plus au moins une couche métallique composée d'Al, de Cu, d'Ag ou d'Au ou d'un alliage à base d'un de ces métaux.

6. Métallisation selon la revendication 5, **caractérisée en ce que** l'au moins une couche composée d'un alliage de base de Mo est déposée sur le côté de la couche métallique composée d'Al, de Cu, d'Ag ou d'Au ou d'un alliage à base d'un de ces métaux tournant le dos au substrat.

7. Utilisation d'une métallisation selon l'une quelconque des revendications précédentes en tant que piste conductrice ou électrode.

8. Procédé pour la préparation d'une métallisation pour un composant en couche mince, **caractérisé en ce qu'**il contient au moins les étapes suivantes :
- mise à disposition d'au moins une cible de pulvérisation
- dépôt d'au moins une couche d'un alliage de base de Mo contenant Al, Ti et des impuretés habituelles, l'au moins une couche composée d'un alliage de base de Mo contenant 10 à 40 % en atomes d'Al ainsi que 5 à 15 % en atomes de Ti et la somme des teneurs en Al et Ti ne dépassant pas 50 % en atomes
- structuration de la métallisation au moyen d'au moins un procédé photolithographique et d'au moins une étape de gravure subséquente.

9. Cible de pulvérisation composée d'un alliage de base de Mo, **caractérisée en ce qu'**elle contient Al, Ti et des impuretés habituelles, la cible de pulvérisation contenant 10 à 40 % en atomes d'Al ainsi que 5 à 15 % en atomes de Ti et la somme des teneurs en Al et Ti ne dépassant pas 50 % en atomes.

10. Cible de pulvérisation selon la revendication 9, **caractérisée en ce qu'**elle ne contient aucune proportion de phase intermétallique détectable au moyen de diffractométrie des rayons X (DRX).

11. Cible de pulvérisation selon la revendication 9 ou 10, **caractérisée en ce qu'**elle contient 15 à 30 % en atomes d'Al.

12. Cible de pulvérisation selon l'une quelconque des revendications 9 à 11, **caractérisée en ce qu'**elle contient 5 à 10 % en atomes de Ti.

13. Cible de pulvérisation selon l'une quelconque des revendications 9 à 12, **caractérisée en ce que** sa dureté se situe en dessous de 400 HV10.

14. Procédé pour la préparation d'une cible de pulvérisation selon l'une quelconque des revendications 9 à 13, **caractérisé en ce qu'**il contient au moins les étapes suivantes :
- mise à disposition d'un mélange en poudre contenant Mo, Al et Ti
- projection au gaz froid (CGS - cold gas spraying) du mélange en poudre sur un matériau de support approprié.
